# EUROPÄISCHE PATENTSCHRIFT

(11) **EP 2 251 459 B1**
(45) Veröffentlichungstag und Bekanntmachung des Hinweises auf die Patenterteilung: **22.08.2012**
(21) Anmeldenummer: 10005022.8
(22) Anmeldetag: 12.05.2010
(51) Int. Cl.: C30B 11/00, C30B 15/02, C30B 29/06, C30B 35/00

(54) **Verfahren und Vorrichtung zur Bereitstellung flüssigen Siliziums**
Method and device for preparing liquid silicon
Procédé et dispositif de préparation de silicium liquide

(30) Priorität: 12.05.2009 DE 102009021003
(43) Veröffentlichungstag der Anmeldung: 17.11.2010
(73) Patentinhaber: centrotherm SiTec GmbH, 89143 Blaubeuren (DE)
(72) Erfinder: Mozer, Albrecht, Dr., 84489 Burghausen (DE); Stadler, Maximilian, Dr., 84533 Haiming (DE)
(74) Vertreter: Heyerhoff & Geiger

(56) Entgegenhaltungen:
- EP-A1- 0 844 318
- EP-A2- 0 283 903
- WO-A1-86/06109
- WO-A2-2007/084934
- US-A- 3 206 286
- US-A- 3 658 119
- US-A- 3 917 241
- US-A- 4 454 096
- US-A- 5 242 531
- US-A1- 2003 150 374
- US-A1- 2005 279 276

## Beschreibung

Die Erfindung betrifft ein Verfahren zur Bereitstellung flüssigen Siliziums gemäß dem Oberbegriff des Anspruchs 1.

Silizium ist insbesondere als Ausgangsmaterial für die Elektronik- und Photovoltaikindustrie von großer Bedeutung. In den meisten Anwendungsfällen kann kein metallurgisches Silizium ohne weitere Vorbehandlung verwendet werden. In der Regel wird das metallurgische Silizium zunächst aufgereinigt und/oder in einer gewünschten Form kristallisiert. Beispielsweise werden polykristalline Siliziumstücke, bei Bedarf nach einer Aufreinigung des Siliziums, aufgeschmolzen und in Form monokristalliner Siliziumstäbe (sog. ingots) rekristallisiert. Hierbei kann beispielsweise das sog. Czochralski-Verfahren Verwendung finden. Alternativ wird in industriellem Umfang eine Rekristallisation in multikristallinen Siliziumblöcken oder auch sog. Siliziumfolien bzw. -bändern durchgeführt.

In den meisten Fällen erfolgt die Rekristallisation aus der flüssigen Phase heraus. Zu diesem Zweck werden Siliziumstücke in beheizbaren Tiegeln aufgeschmolzen. Bei den Siliziumstücken kann es sich beispielsweise um zertrümmerte, nach dem Siemens-Verfahren aus der Gasphase abgeschiedene Siliziumstäbe oder metallurgisches Silizium handeln. Grundsätzlich sind alle Formen festen Siliziums verwendbar, insbesondere auch mittels eides Wirbelbettverfahrens hergestellte Siliziumkörper.

Zum Aufschmelzen wird das feste Silizium in Tiegel eingefüllt. Dabei entstehen, je nach Form des eingesetzten Siliziums größers oder kleinere, Hohlräume. Dies führt dazu, dass nach dem Aufschmelzen des in einem voll befüllten Tiegel befindlichen festen Siliziums dieser Tiegel nur noch zu einem Teil gefüllt ist. Der Füllstand des Tiegels hat jedoch häufig Einfluss auf die Menge des in einem Verfahrenszyklus rekristallisierten Siliziums. Daher wird ein möglichst hoher Füllstand angestrebt. Zu diesem Zweck wird das feste Silizium in den Tiegeln beispielsweise gehäuft angeordnet, sodass ein Teil der Siliziumstücke über den Tiegel hinausragt. Selbst bei dieser Vorgehensweise ist der Tiegel jedoch nach Aufschmelzen des festen Siliziums üblicherweise nur noch zu 50 bis 70 % gefüllt. Aus diesem Grund wird vor der Kristallisierung in der Regel weiteres festes Silizium zu dem bereits aufgeschmolzenen Silizium zugegeben. Dies wird häufig als Nachchargieren bezeichnet.

Das Aufschmelzen dieses nachträglich zugeführten festen Siliziums nimmt eine gewisse Zeit in Anspruch. Hinzu tritt, dass neben einem hohen Füllstand in den meisten Fällen eine homogene Siliziumschmelze erforderlich ist, um die erforderliche Güte des rekristallisierten Siliziums sicherzustellen. Bei derzeit in der industriellen Fertigung im Einsatz befindlichen Tiegeln nimmt die nachträgliche Zufuhr festen Siliziums, dessen Aufschmelzung und die Homogenisierung der Siliziumschmelze etwa zwölf Stunden in Anspruch. Gegenüber einem Verfahren, bei welchem keine nachträgliche Zufuhr festen Siliziums, also kein Nachchargieren, erforderlich ist, bedeutet dies eine Reduktion der Produktionskapazität von etwa 20 - 25 %, mit welcher der gewünschte hohe Füllstand an flüssigem Silizium erkauft wird. Nachchargierende Verfahren sind in US 5,242,531 und EP 0 283 903 A2 beschrieben.

Vor diesem Hintergrund liegt der vorliegenden Erfindung die Aufgabe zugrunde, ein Verfahren zur Verfügung zu stellen, mit welchem aufwandsgünstig Tiegel mit einem hohen Füllstand an flüssigem Silizium bereitgestellt werden können und welches zur Herstellung blockgegossenen Siliziums geeignet ist. Diese Aufgabe wird gelöst durch ein Verfahren mit den Merkmalen des Anspruchs 1.

Vorteilhafte Weiterbildungen sind Gegenstand abhängiger Unteransprüche.

Der Grundgedanke des erfindungsgemäßen Verfahrens besteht darin, wenigstens einen Tiegel mit festem Silizium zu befüllen, dieses aufzuschmelzen und flüssiges Silizium zu dem in dem wenigstens einen Tiegel befindlichen Silizium zuzuführen, wobei das in dem wenigstens einen Tiegel befindliche Silizium zumindest teilweise kristallisiert wird und die Kristallisation nach der Zufuhr des flüssigen Siliziums erfolgt.

Die Kristallisation setzt voraus, dass das in dem wenigstens einen Tiegel befindliche Silizium sich in einem flüssigen Zustand befindet, also zuvor aufgeschmolzen wurde.

Das erfindungsgemäße Verfahren hat sich bei der Herstellung von blockgegossenen Silizium als vorteilhaft erwiesen. Die Kristallisation erfolgt nach vollständiger Zufuhr des flüssigen Siliziums, und somit weitgehendem Auffüllen des wenigstens einen Tiegels mit flüssigem Silizium, und hinreichender Homogenisierung des flüssigen Siliziums. Diese Verfahrensweise ist insbesondere anwendbar bei der Herstellung von blockgegossenem Silizium, bei dessen Erstarrung eine planare fest-flüssig-Phasengrenze durch die Siliziumschmelze geführt wird.

Durch die Zufuhr flüssigen Siliziums entfällt der Zeitaufwand für das Aufschmelzen zugeführten Siliziums. Gegenüber einer Zufuhr und Aufschmelzung festen Siliziums gemäß dem Stand der Technik kann bei Einsatz derzeit üblicher Tiegel eine Zeitersparnis von bis zu 10 Stunden erzielt werden.

Die Zufuhr des flüssigen Siliziums kann grundsätzlich zu jedem Zeitpunkt erfolgen, zu welchem das in dem wenigstens einen Tiegel befindliche feste Silizium zumindest teilweise bereits geschmolzen wurde. Bevorzugt erfolgt die Zufuhr flüssigen Siliziums jedoch erst, nachdem das zuvor in den wenigstens einen Tiegel eingefüllte feste Silizium vollständig geschmolzen wurde.

Eine Ausgestaltungsvariante des erfindungsgemäßen Verfahrens sieht vor, dass das flüssige Silizium aus einem Vorratsbehälter zugeführt wird. Dieser ist vorzugsweise gegenüber der Umgebung thermisch isoliert und/oder mit einer Heizeinrichtung versehen.

Bei einer Weiterbildung der Erfindung wird als Vorratsbehälter ein Vorratstiegel verwendet, in welchem festes Silizium aufgeschmolzen wird. Dieses aufgeschmolzene Silizium stellt sodann das flüssige Silizium dar, welches dem wenigstens einen Tiegel zuführbar ist. Der Vorratstiegel kann grundsätzlich baugleich zu dem wenigstens einen Tiegel ausgeführt sein oder sich von diesem in seiner baulichen Ausgestaltung unterscheiden.

Vorteilhafterweise werden das feste Silizium in dem Vorratstiegel und das feste Silizium in dem wenigstens einen Tiegel mit zeitlichem Überlapp aufgeschmolzen. Es existiert somit ein Zeitraum, in welchem sowohl in dem wenigstens einen Tiegel als auch in dem Vorratstiegel jeweils Silizium in fester und flüssiger Phase vorliegt. Bei einer vorteilhaften Ausgestaltungsvariante wird der zeitliche Überlapp derart gewählt, dass zum Zeitpunkt der vollständigen Verflüssigung des in dem wenigstens einen Tiegel befindlichen Siliziums auch das in dem Vorratstiegel befindliche Silizium vollständig verflüssigt ist.

In der Praxis hat es sich bewährt, mindestens zwei Tiegel vorzusehen, welche anfänglich mit festen Silizium befüllt werden. Insbesondere eine Zahl von vier Tiegeln hat sich bewährt. Vorteilhafterweise wird den mindestens zwei Tiegeln flüssiges Silizium aus demselben Vorratsbehälter zugeführt.

Vorteilhafterweise wird den mindestens zwei Tiegeln gleichzeitig flüssiges Silizium zugeführt. Das zugeführte Silizium kann dabei grundsätzlich aus verschiedenen Vorratsbehältern zugeführt werden. Als besonders vorteilhaft hat es sich jedoch erwiesen, den mindestens zwei Tiegeln gleichzeitig flüssiges Silizium aus demselben Vorratsbehälter zuzuführen.

Alternativ kann den mindestens zwei Tiegeln flüssiges Silizium mit zeitlichem Versatz zugeführt werden. In dieser Weise lässt sich eine serielle Befüllung der mindestens zwei Tiegel realisieren. Das zugeführte Silizium kann dabei wiederum aus verschiedenen oder demselben Vorratsbehälter zugeführt werden.

Abweichend von der Erfindung kann flüssiges Silizium zugeführt werden, während in dem wenigstens einen Tiegel befindliches Silizium kristallisiert wird. Dies kann beispielsweise der Fall sein, wenn die Kristallisation durch das Ziehen von Siliziumfolien bzw. Siliziumbändern erfolgt. Hierfür sind verschiedene Technologien bekannt. Beispielsweise werden Ziehdrähte durch die Schmelze gezogen, zwischen welchen sich eine Siliziumhaut ausbildet, welche im Weiteren erstarrt. Die Kristallisation kann in einem anderen Beispiel in Form von Siliziumstäben (ingots) erfolgen, beispielsweise mittels eines Czochralski-Verfahrens.

Sofern die Kristallisation des flüssigen Siliziums in dem wenigstens einen Tiegel erfolgt, oder unmittelbar aus dem wenigstens einen Tiegel hinaus wie beim Folienziehen, so wird vorzugsweise der wenigstens eine Tiegel als Kristallisationstiegel ausgebildet. D. h. es wird ein Tiegel verwendet, der beispielsweise mit speziellen Beschichtungen wie Siliziumnitrit oder Graphit versehen ist, um die Gefahr eines Verunreinigungseintrages zu verringern. Je nach dem verwendeten Kristallisationsverfahren können die Kristallisationstiegel andere oder zusätzliche spezielle Eigenschaften aufweisen.

Eine Vorrichtung zur Durchführung des erfindungsgemäßen Verfahrens sieht wenigstens einen beheizbaren Tiegel zum Aufschmelzen festen Siliziums und wenigstens einen Vorratsbehälter für flüssiges Silizium vor. Dabei ist flüssiges Silizium aus dem Vorratsbehälter dem wenigstens einen Tiegel zuführbar.

Bei einer Weiterbildung dieser Vorrichtung ist der Vorratsbehälter als beheizbarer Vorratstiegel ausgeführt, in welchem festes Silizium aufschmelzbar ist.

Bevorzugt ist der wenigstens eine beheizbare Tiegel durch mindestens zwei Tiegel gebildet. Auf diese Weise ist eine rationellere Durchführung des Verfahrens möglich.

Eine Weiterbildung der Vorrichtung sieht ferner vor, dass flüssiges Silizium aus dem Vorratsbehälter den mindestens zwei Tiegeln gleichzeitig zuführbar ist.

Bei einer Ausführungsvariante der Vorrichtung ist der wenigstens eine Tiegel als Kristallisationstiegel ausgeführt. Kristallisationstiegel sind üblicherweise auf den jeweiligen Kristallisationsprozess angepasst und beispielsweise, wie oben dargelegt, mit speziellen Beschichtungen versehen. Weiterhin können aufwändige Heizeinrichtungen und zugehörige Steuerungen und Regelungen vorgesehen sein, welche den Fertigungsaufwand eines Kristallisationstiegels gegenüber einem gewöhnlichen Schmelztiegel signifikant erhöhen. Dennoch kann auch der Vorratsbehälter als Kristallisationstiegel ausgeführt sein, selbst wenn in diesem keine Kristallisation erfolgt. Aus Kostengründen wird jedoch der Vorratstiegel bevorzugt aufwandsgünstiger ausgestaltet. Beispielsweise können Steuerungen und Regelungen für Heizeinrichtungen aufwandsgünstiger ausgeführt sein. Je nach gewünschtem Reinheitsgrad des zugeführten flüssigen Siliziums ist auch eine Vereinfachung der Beschichtungen oder die Wahl günstigerer Materialien für die Ausbildung des Vorratstiegels denkbar.

Eine vorteilhafte Ausführungsvariante sieht vor, dass der Vorratsbehälter in größerer Höhe als der wenigstens eine Tiegel derart angeordnet ist, sodass flüssiges Silizium aus dem Vorratsbehälter dem wenigstens einen Tiegel gravitationsgetrieben zuführbar ist. Dies ermöglicht einen Verzicht auf aufwändige Fördereinrichtungen für flüssiges Silizium.

Vorteilhafterweise ist der Vorratsbehälter mit wenigstens einem Auslass versehen und derart relativ zu dem wenigstens einen Tiegel anordenbar, dass diesem flüssiges Silizium über den wenigstens einen Auslass zuführbar ist. Die konkrete Ausgestaltung des Auslasses ist grundsätzlich frei wählbar. Beispielweise kann der Auslass durch eine verschließbare Öffnung in der Bodenwandung des Vorratsbehälters gebildet sein, wobei diese Öffnung sodann vertikal über dem wenigstens einen Tiegel anordenbar wäre.

Eine weitere Ausgestaltungsvariante sieht vor, dass der Vorratsbehälter mit dem wenigstens einen Tiegel über wenigstens eine Zuleitung verbunden ist, mittels welcher flüssiges Silizium aus dem Vorratsbehälter dem wenigstens einen Tiegel zuführbar ist. Eine derartige Zuleitung kann beispielsweise in einen Auslass des Vorratsbehälters münden. Die Zufuhr des flüssigen Siliziums über die Zuleitung kann dabei mittels einer Fördereinrichtung, beispielsweise einer Pumpe, erfolgen. Eine gravitationsgetriebene Zufuhr ist offensichtlich ebenfalls denkbar.

Im Folgenden wird die Erfindung anhand von Figuren näher erläutert. Soweit zweckdienlich, sind hierin gleichwirkende Elemente mit gleichen Bezugszeichen versehen. Es zeigen:
- Figur 1:: Schematische Darstellung eines ersten Teils eines Ausführungsbeispiels eines erfindungsgemäßen Verfahrens sowie Prinzipdarstellung einer ersten Ausgestaltungsvariante einer Vorrichtung zu dessen Durchführung.
- Figur 2:: Schematische Darstellung einer Verfahrensvariante, bei welchem eine Kristallisation bei gleichzeitiger Zufuhr flüssigen Siliziums erfolgt.
- Figur 3:: Schematische Darstellung eines zweiten Teils des Ausführungsbeispiels des erfindungsgemäßen Verfahrens.
- Figur 4:: Prinzipdarstellung eines erfindungsgemäßen Verfahrens, bei welchem flüssiges Silizium mehreren Tiegeln gleichzeitig zugeführt wird, sowie schematische Darstellung einer hierzu geeigneten Vorrichtung.
- Figur 5:: Schematische Darstellung eines weiteren Ausführungsbeispiels einer geeigneten Vorrichtung.
- Figur 6:: Schematische Teildarstellung eines weiteren Ausführungsbeispiels des erfindungsgemäßen Verfahrens.

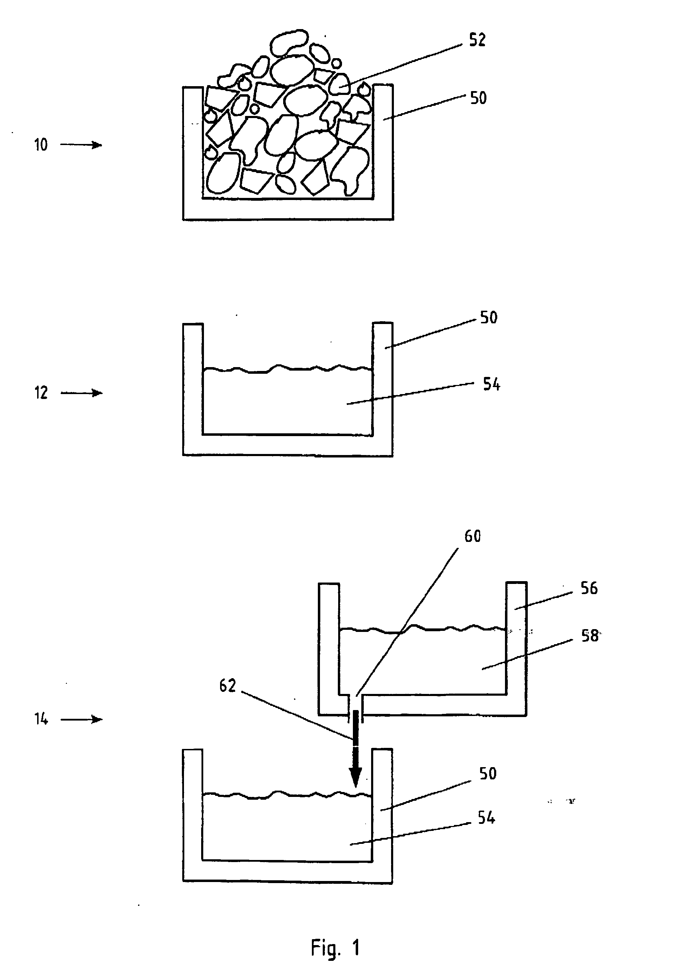

Figur 1 zeigt in schematischer Darstellung unter anderem ein Befüllen 10 eines Tiegels 50 mit festen Silizium 52. Das feste Silizium 52 ist dabei aus Siliziumstücken verschiedener Größen und verschiedener Geometrien gebildet. Wie Figur 1 zeigt, ist das feste Silizium 52 gehäuft in dem Tiegel 50 angeordnet, um nach einem Aufschmelzen 12 des festen Siliziums 52 eine möglichst hohen Füllstand in dem Tiegel 50 zu erreichen.

Wie Figur 1 in der mittleren Darstellung illustriert, ist der Tiegel 50 dennoch nach dem Aufschmelzen 12 des festen Siliziums 52 nur teilweise mit aufgeschmolzenem Silizium 54 gefüllt. Infolgedessen wird im Weiteren flüssiges Silizium 58 aus einem Vorratstiegel 56 zugeführt 14. Die in Figur 1 in der untersten Abbildung dargestellte erfindungsgemäße Vorrichtung sieht zu diesem Zweck vor, dass der Vorratstiegel 56 in größerer Höhe als Tiegel 50 angeordnet ist und mit einem Auslass 60 versehen ist, welcher in der Bodenwandung des Vorratstiegels 56 angeordnet ist. Der Auslass 60 ist verschließbar ausgeführt, wobei der besseren Übersicht halber der zugehörige Verschluss in Figur 1 nicht dargestellt ist. Ferner ist der Auslass 60 über dem Tiegel 50, genauer über der Öffnung des Tiegels 50, angeordnet, sodass bei geöffnetem Auslass 60 das zugeführte Silizium 62 infolge der Gravitationswirkung in den Tiegel 50 gelangt.

Der Vorratstiegel 56 kann grundsätzlich fest relativ zu dem Tiegel 50 angeordnet sein. Alternativ ist denkbar, dass der Vorratstiegel 56 beweglich relativ zu dem Tiegel 50 ausgeführt und in die in der Figur 1 dargestellte Position verbringbar ist.

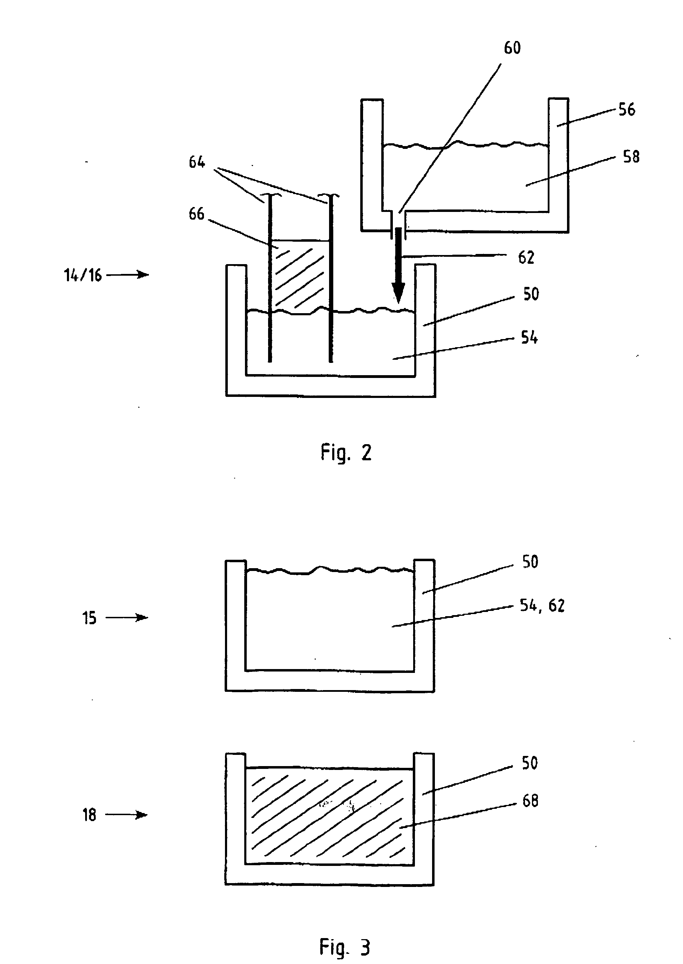

Figur 2 illustriert in Verbindung mit Figur 1 ein Verfahren, in welchem, wie durch den Pfeil 62 angedeutet, flüssiges Silizium 62 zugeführt wird 14, während in dem Tiegel 50 befindliches Silizium 54 kristallisiert wird 16. Anstelle der in Figur 1 dargestellten schlichten Zufuhr flüssigen Siliziums wird im Ausführungsbeispiel der Figur 2 im Anschluss an das Befüllen 10 des Tiegels und das Aufschmelzen 12 des festen Siliziums 52 das flüssige Silizium 58 aus dem Vorratstiegel 56 zugeführt 14 (vgl. Pfeil 62), während Ziehdrähte 64 durch das aufgeschmolzene Silizium 54 und zugeführtes Silizium 62 gezogen werden. Dabei wird zwischen diesen Ziehdrähten 64 eine Siliziumhaut ausgebildet, welche als Siliziumfolie 66 kristallisiert.

In einer anderen Ausgestaltungsvariante können die Ziehdrähte 64 durch Siliziumdünnstäbe ersetzt werden, an welchen in dem Tiegel befindliches Silizium gemäß einem Czochralski-Ziehverfahren kristallisiert wird. Grundsätzlich kann die Erfindung in Verbindung mit allen Kristallisierungsverfahren verwendet werden, bei welchem ein Keimkristall verwendet wird. Die Erfindung ist jedoch nicht auf die Verwendung bei derartigen Verfahren beschränkt, sondern kann insbesondere auch bei Kristallisationsverfahren zur Anwendung kommen, bei welchem kein Keimkristall eingesetzt wird.

Bei dem erfindungsgemäßen Verfahren erfolgt die Kristallisation erst nach der Zufuhr 14 des flüssigen Siliziums 58. Ein Ausführungsbeispiel solch eines Verfahrens illustriert Figur 3 in Verbindung mit Figur 1. Figur 3 zeigt zunächst die Beendigung 15 der Figur 1 dargestellten Zufuhr 14 flüssigen Siliziums 58 aus dem Vorratstiegel 56. Zu diesem Zeitpunkt ist der Tiegel 50 nahezu vollständig gefüllt mit aufgeschmolzenem Silizium 54 und zugeführtem Silizium 62. Hieran schließt sich die Kristallisation 18 des flüssigen Siliziums 54 und des zugeführten Siliziums 62 an. Das Ergebnis dieser Kristallisation 18 zeigt Figur 3 in der unteren Darstellung, in welcher ein in dem Tiegel 50 kristallisierter Siliziumblock 68 erkennbar ist. Die Kristallisation 18 kann beispielsweise mittels gerichteter Erstarrung erfolgen, vorzugsweise unter Verwendung einer planaren fest-flüssig-Phasengrenze.

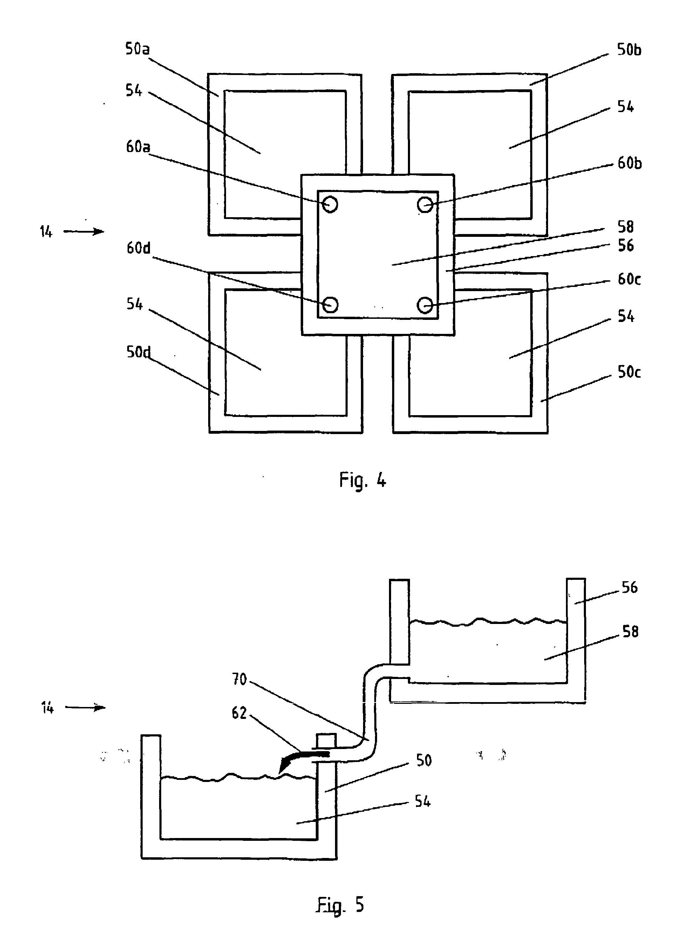

Figur 4 illustriert in einer Aufsicht einerseits eine Ausführungsvariante des erfindungsgemäßen Verfahrens, zum anderen eine zur Durchführung dieser Ausführungsvariante geeignete Vorrichtung. So sind in der Darstellung der Figur 4 vier Tiegel 50a, 50b, 50c, 50d vorgesehen, über welchen eine Vorratstiegel 56 angeordnet ist. Der Vorratstiegel 56 ist demzufolge in größerer Höhe angeordnet als die vier Tiegel 50a, 50b, 50c, 50d. Der Vorratstiegel 56 ist mit Auslassöffnungen 60a, 60b, 60c, 60d versehen, welche wiederum in der Bodenwandung des Vorratstiegels 56 angeordnet und verschließbar ausgeführt sind. Die Auslässe 60a, 60b, 60c, 60d sind dabei über den verschiedenen Tiegeln 50a, 50b, 50a, 50d angeordnet, genauer über deren Öffnungen, sodass in dem Vorratstiegel 56 befindliches flüssiges Silizium über die Auslässe 60a, 60b, 60c, 60d, den verschiedenen Tiegeln 50a, 50b, 50c, 50d zuführbar ist. Diese Zufuhr 14 kann mit der dargestellten Vorrichtung wiederum gravitations-getrieben erfolgen. Der Vorratstiegel 56 kann in der in Figur 4 dargestellten Position relativ zu den Tiegeln 50a, 50b, 50c, 50d fixiert oder in die dargestellte Position verbringbar sein, beispielsweise durch einen Schenkmechanismus.

Unter der Annahme, dass die Auslässe 60a, 60b, 60c, 60d geöffnet sind illustriert Figur 4 somit auch ein Zuführen 14 des flüssigen Siliziums 58 aus dem Vorratstiegel 56 zudem in den Tiegeln 50a, 50b, 50c, 50d befindlichen Silizium 54. Den vier Tiegeln 50, 50b, 50c, 50d wird dabei offensichtlich gleichzeitig flüssiges Silizium 58 aus demselben Vorratsbehälter 56 zugeführt.

Figur 5 zeigt ein weiteres Ausführungsbeispiel einer Vorrichtung. Bei dieser ist der Vorratstiegel 56 wiederum in größerer Höhe angeordnet als der eine Tiegel 50. somit ist erneut eine gravitationsgetriebene Zufuhr flüssigen Siliziums 58 aus dem Vorratstiegel 56 zu dem in dem Tiegel 50 befindlichem aufgeschmolzenen Silizium 54 möglich. Die Zufuhr erfolgt in der schematisch dargestellten Ausführungsvariante der Figur 5 über eine Zuleitung 70, welche den Vorratstiegel 56 mit dem Tiegel 50 verbindet. Der Pfeil 62 stellt das über die Zuleitung 70 zugeführte Silizium dar.

Entgegen der Darstellung der Figur 5 kann der Vorratstiegel 56 in einer alternativen Ausgestaltungsvariante auch auf gleicher Höhe wie der Tiegel 50 oder darunter angeordnet werden. Die Zufuhr 14 flüssige Siliziums 58 aus dem Vorratstiegel 56 zu dem aufgeschmolzenen Silizium 54 in dem Tiegel 50 kann dennoch über die Zuleitung 70 erfolgen, jedoch ist eine Fördereinrichtung, beispielsweise eine Pumpe, vorzusehen.

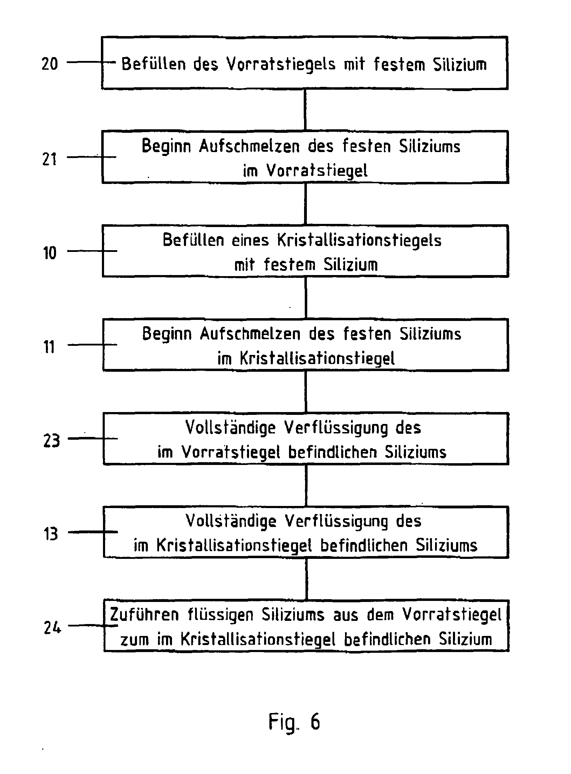

Figur 6 illustriert in einer schematischen Teildarstellung eine Ausgestaltungsvariante des erfindungsgemäßen Verfahrens, bei welchem das feste Silizium in dem Vorratstiegel 56 und das feste Silizium 52 in dem wenigstens einen Tiegel mit zeitlichem Überlapp aufgeschmolzen werden. Hierzu wird zunächst der Vorratstiegel mit festem Silizium befüllt 20. Hieran schließt sich der Beginn des Aufschmelzens 21 dieses festen Siliziums im Vorratstiegel 56 an.

Im Folgenden wird der im vorliegenden Ausführungsbeispiel als Kristallisationstiegel ausgeführte wenigstens eine Tiegel mit festem Silizium befüllt 10. Hieran schließt sich der Beginn 11 des Aufschmelzens des festen Siliziums im Kristallisationstiegel an.

Im Weiteren wird eine vollständige verflüssigung 23 des im Vorratstiegel befindlichen Siliziums erreicht, ehe eine vollständige Verflüssigung 13 des im Kristallisationstiegel befindlichen Siliziums erzielt wird.

Auf diese Weise liegt zum Zeitpunkt der vollständigen Verflüssigung 13 des im Kristallisationstiegel befindlichen Siliziums auch im Vorratstiegel flüssiges Silizium vor, welches verzögerungsfrei dem im Kristallisationstiegel befindlichen Silizium zugeführt 24 werden kann.

Je nach den Anforderungen des jeweiligen Anwendungsfalls können offensichtlich die in den Ausführungsbeispielen der Figuren 1 bis 6 dargestellten Weiterbildungen in geeigneter Weise miteinander kombiniert werden. Beispielsweise kann in jedem der dargestellten Ausführungsbeispiele der Tiegel 50, 50a, 50b, 50c, 50d als Kristallisationstiegel ausgeführt sein. Weiterhin kann eine Zufuhr 14 flüssigen Siliziums während der Kristallisation entsprechend dem Ausführungsbeispiel der Figur 2 auch in den Ausführungsvarianten der Figuren 4 oder 5 vorgesehen werden. Des Weiteren ist insbesondere eine Durchführung des Verfahrens gemäß der Darstellung in der Figur 6 mit allen in den Figuren 1 bis 5 dargestellten erfindungsgemäßen Vorrichtungen möglich.

### Bezugszeichenliste

- 10: Befüllen des Tiegels
- 11: Beginn Aufschmelzen Silizium in Kristallisationstiegel
- 12: Aufschmelzen des festen Siliziums
- 13: Vollständige Verflüssigung Silizium in Kristallisations- tiegel
- 14: Zuführen flüssigen Siliziums
- 15: Beendigung der Zufuhr flüssigen Siliziums
- 16: Kristallisieren flüssigen Siliziums
- 18: Kristallisieren flüssigen Siliziums
- 20: Befüllen Vorratstiegel
- 21: Beginn Aufschmelzen Silizium in Vorratstiegel
- 23: Vollständige Verflüssigung Silizium in Vorratstiegel
- 24: Zuführen flüssigen Silizium aus Vorratstiegel
- 50: Tiegel
- 50a: Tiegel
- 50b: Tiegel
- 50c: Tiegel
- 50d: Tiegel
- 52: festes Silizium
- 54: aufgeschmolzenes Silizium
- 56: Vorratstiegel
- 58: flüssiges Silizium
- 60: Auslass
- 60a: Auslass
- 60b: Auslass
- 60c: Auslass
- 60d: Auslass
- 62: zugeführtes Silizium
- 64: Ziehdrähte
- 66: kristallisierte Siliziumfolie
- 68: kristallisierter Siliziumblock

- 70: Zuleitung

## Patentansprüche

1. Verfahren zur Bereitstellung flüssigen Siliziums aufweisend die Verfahrensschritte des
- Befüllens (10) wenigstens eines Tiegels (50; 50a, 50b, 50c, 50d) mit festem Silizium (52),
- des Aufschmelzens (12) des in dem wenigstens einen Tiegel (50; 50a, 50b, 50c, 50d) befindlichen festen Siliziums (52),
- des Zufuhren (14; 24) flüssigen Siliziums (58) zu dem in dem wenigstens einen Tiegel (50; 50a, 50b, 50c, 50d) befindlichen Silizium (54) und
- des zumindest teilweisen Kristallisierens (16; 18) des in dem wenigstens einen Tiegel (50; 50a, 50b, 50c, 50d) befindlichen Siliziums (54, 62),
**dadurch gekennzeichnet,**
**dass** die Kristallisation (18) nach der Zufuhr (14) des flüssigen Siliziums (58) erfolgt.

2. Verfahren nach Anspruch 1,
**dadurch gekennzeichnet,**
**dass** das flüssige Silizium (58) aus einem Vorratsbehälter (56) zugeführt wird (14; 24) und als Vorratsbehälter (56) ein Vorratstiegel (56) verwendet wird, in welchem festes Silizium aufgeschmolzen wird (21, 23).

3. Verfahren nach Anspruch 2,
**dadurch gekennzeichnet,**
**dass** da3 feste Silizium in dem Vorratstiegel (56) und dass feste Silizium (52) in dem wenigstens einen Tiegel (50; 50a, 50b, 50c, 50d) mit zeitlichem Überlapp aufgeschmolzen werden (11, 13, 21, 23), wobei der zeitliche Überlapp bevorzugt derart gewählt wird, dass zum Zeitpunkt der vollständigen Verflüssigung (13) des in dem wenigstens einen Tiegel (50) befindlichen Siliziums (52) auch das in dem Vorratstiegel (56) befindliche Silizium vollständig verflüssigt ist (23).

4. Verfahren nach einem der vorangegangenen Ansprüche,
**dadurch gekennzeichnet,**
**dass** mindestens zwei Tiegel (50a, 50b, 50c, 50d) vorgesehen werden, vorzugsweise vier.

5. Verfahren nach Anspruch 4,
**dadurch gekennzeichnet,**
**dass** den mindestens zwei Tiegeln (50a, 50b, 50c, 50d) gleichzeitig flüssiges Silizium (58) zugeführt wird (14).

6. Verfahren nach Anspruch 4,
**dadurch gekennzeichnet,**
**dass** den mindestens zwei Tiegeln (50a, 50b, 50c, 50d) gleichzeitig flüssiges Silizium (58) aus demselben Vorratsbehälter (56) zugeführt wird.

## Claims

1. A method for providing liquid silicon comprising the method steps of
- filling (10) at least one crucible (50; 50a, 50b, 50c, 50d) with solid silicon (52),
- melting (12) the solid silicon (52) situated in the at least one crucible (50; 50a, 50b, 50c, 50d),
- feeding (14; 24) liquid silicon (58) to the silicon (54) situated in the at least one crucible (50; 50a, 50b, 50c, 50d) and
- at least partly crystallizing (16; 18) the silicon (54, 62) situated in the at least one crucible (50; 50a, 50b, 50c, 50d),
**characterized in that** the crystallization (18) is effected after the feeding (14) of the liquid silicon (58).

2. The method according to claim 1,
**characterized in that** the liquid silicon (58) is fed (14; 24) from a supply container (56) and the supply container (56) used is a supply crucible (56), in which solid silicon is melted (21, 23).

3. The method according to claim 2,
**characterized in that** the solid silicon in the supply crucible (56) and the solid silicon (52) in the at least one crucible (50; 50a, 50b, 50c, 50d) are melted (11, 13, 21, 23) with a temporal overlap, the temporal overlap preferably being chosen in such a way that, at the point in time of the complete liquefaction (13) of the silicon (52) situated in the at least one crucible (50), the silicon situated in the supply crucible (56) is also completely liquefied (23).

4. The method according to any of the preceding claims,
**characterized in that** at least two crucibles (50a, 50b, 50c, 50d) are provided, preferably four.

5. The method according to claim 4,
**characterized in that** liquid silicon (58) is fed (14) to the at least two crucibles (50a, 50b, 50c, 50d) simultaneously.

6. The method according to claim 4,
**characterized in that** liquid silicon (58) is fed to the at least two crucibles (50a, 50b, 50c, 50d) simultaneously from the same supply container (56).

## Revendications

1. Procédé pour la mise à disposition de silicium liquide qui présente les étapes de procédé de:
- remplissage (10) d'au moins un creuset (50; 50a, 50b, 50c, 50d) avec du silicium solide (52),
- fusion (12) du silicium solide (52) qui se trouve dans le creuset qui existe au moins (50; 50a, 50b, 50c, 50d),
- d'amenée (14; 24) de silicium liquide (58) au silicium (54) qui se trouve dans le creuset qui existe au moins (50; 50a, 50b, 50c, 50d) et
- de cristallisation au moins partielle (16; 18) du silicium (54, 62) qui se trouve dans le creuset qui existe au moins (50; 50a, 50b, 50c, 50d),
**caractérisé en ce que** la cristallisation (18) est effectuée après l'amenée (14) du silicium liquide (58).

2. Procédé selon la revendication 1,
**caractérisé en ce que** le silicium liquide (58) est amené à partir d'un réservoir de stockage (56) et qu'un creuset de stockage (56) dans lequel du silicium solide est fondu (21, 23) est utilisé comme réservoir de stockage (56).

3. Procédé selon la revendication 2,
**caractérisé en ce que** le silicium solide est fondu (11, 13, 21, 23) dans le réservoir de stockage (56) et le silicium solide (52) est fondu (11, 13, 21, 23) dans le creuset qui existe au moins (50; 50a, 50b, 50c, 50d) avec un chevauchement dans le temps, le chevauchement dans le temps étant sélectionné de préférence tel qu'au moment de la liquéfaction complète (13) du silicium (52) qui se trouve dans le creuset qui existe au moins (50) le silicium qui se trouve dans le creuset de stockage (56) est également complètement liquéfié (23).

4. Procédé selon l'une des revendications précédentes,
**caractérisé en ce qu'**au moins deux creusets (50a, 50b, 50c, 50d), de préférence quatre creusets, sont prévus.

5. Procédé selon la revendication 4,
**caractérisé en ce que** du silicium liquide (58) est amené (14) simultanément aux deux creusets qui existent au moins (50a, 50b, 50c, 50d).

6. Procédé selon la revendication 4,
**caractérisé en ce que** du silicium liquide (58) provenant du même réservoir de stockage (56) est amené simultanément aux deux creusets qui existent au moins (50a, 50b, 50c, 50d).
